# EUROPEAN PATENT APPLICATION

(11) **EP 4 832 685 A1**
(43) Date of publication of application: **28.10.2026**
(21) Application number: 26174246.4
(22) Date of filing: 23.04.2026
(51) Int. Cl.: H05K 7/20, H05K 5/00

(54) **METALIZED PLASTIC HOUSING FOR ELECTRONIC COMPONENTS**

(30) Priority: 24.04.2025 US 202519188111
(71) Applicant: Littelfuse, Inc., Rosemont, Illinois 60018 (US)
(72) Inventor: Vowles, Chris, Rosemont 60018 (US)
(74) Representative: Arnold & Siedsma

(57) **Abstract**

An automobile electronic control unit (ECU) including a housing including a base structure formed of plastic and having a plurality of holes formed therein, wherein each of the plurality of holes extends from an interior surface of the base structure to an exterior surface of the base structure. The automobile ECU further includes a metallic coating covering the interior and exterior surfaces of the base structure and filling the plurality of holes to form conductive vias. The automobile ECU further includes a printed circuit board disposed within the housing, a plurality of electronic components mounted on the printed circuit board, and a connection receptacle extending from the housing and adapted to receive a connector of a wiring harness, the connection receptacle electrically connected to the plurality of electronic components.

## Description

### BACKGROUND

### Field

The present disclosure relates generally to housings for electronic components and relates more particularly to a heat dissipating metalized plastic housing for electronic components.

### Description of Related Art

Automobile electronic control units (ECUs) are essential components in modern vehicles, responsible for managing and regulating various vehicle functions such as engine performance, transmission control, braking systems, and driver assistance features. ECUs typically include complex electronic circuits, including microprocessors and power transistors, which generate heat during operation.

Efficient heat dissipation is a critical concern for ECUs, as excessive heat can degrade performance, reduce the lifespan of electronic components, and potentially lead to system failures. To address this challenge, ECUs often have housings that are designed to facilitate heat dissipation. Traditionally, such housings are made of metallic materials, such as aluminum or magnesium alloys, which possess high thermal conductivity properties that help to dissipate heat away from sensitive electronic components.

While metal housings offer effective thermal management, they also present certain disadvantages. For example, metal housings are typically heavy, contributing to increased vehicle weight, which can negatively impact fuel efficiency and overall vehicle performance. Additionally, metal housings are expensive due to material costs and required tooling, increasing the manufacturing costs of ECUs and, consequently, the overall production costs of vehicles.

Given these limitations, there is a need for improved ECU housing designs that provide effective heat dissipation while reducing weight and cost. It is with respect to these and other considerations that the present improvements may be useful.

### SUMMARY

This Summary is provided to introduce a selection of concepts in a simplified form further described below in the Detailed Description. This Summary is not intended to identify key features or essential features of the claimed subject matter, nor is the summary intended as an aid in determining the scope of the claimed subject matter.

An automobile electronic control unit (ECU) according to the present disclosure includes a housing including a base structure formed of plastic and having a plurality of holes formed therein, wherein each of the plurality of holes extends from an interior surface of the base structure to an exterior surface of the base structure. The automobile ECU further includes a metallic coating covering the interior and exterior surfaces of the base structure and filling the plurality of holes to form conductive vias. The automobile ECU further includes a printed circuit board disposed within the housing, a plurality of electronic components mounted on the printed circuit board, and a connection receptacle extending from the housing and adapted to receive a connector of a wiring harness, the connection receptacle electrically connected to the plurality of electronic components.

A housing for an electronic device according to the present disclosure most preferably includes a housing including a base structure formed of plastic and having a plurality of holes formed therein, wherein each of the plurality of holes extends from an interior surface of the base structure to an exterior surface of the base structure. The housing preferably further includes a metallic coating covering the interior and exterior surfaces of the base structure and filling the plurality of holes to form conductive vias.

A method of manufacturing a housing for an electronic device according to the present disclosure includes forming a base structure from plastic, the base structure having a plurality of holes extending between interior and exterior surfaces thereof, applying a priming agent to the interior and exterior surfaces of the base structure, and applying a metallic coating over the priming agent, wherein the metallic coating fills the plurality of holes to form conductive vias.

### BRIEF DESCRIPTION OF THE DRAWINGS

**FIG. 1** is a perspective illustrating an electronic control unit in accordance with the present disclosure;
**FIG. 2** is a cutaway view illustrating the electronic control unit shown in **FIG. 1****;**
**FIG. 3** is a cross-sectional view illustrating the electronic control unit shown in **FIG. 1****;** and
**FIG. 4** is a flow diagram illustrating a method of manufacturing a housing in accordance with the present disclosure.

### DETAILED DESCRIPTION

A heat dissipating housing for electronic components and an associated method of manufacture according to the present disclosure will now be described more fully hereinafter with reference to the accompanying drawings. The heat dissipating housing and the method may, however, be exemplified in many different forms and should not be construed as being limited to the examples set forth herein. Rather, these examples are provided so that this disclosure will convey certain exemplary aspects of the heat dissipating housing and the method to those skilled in the art.

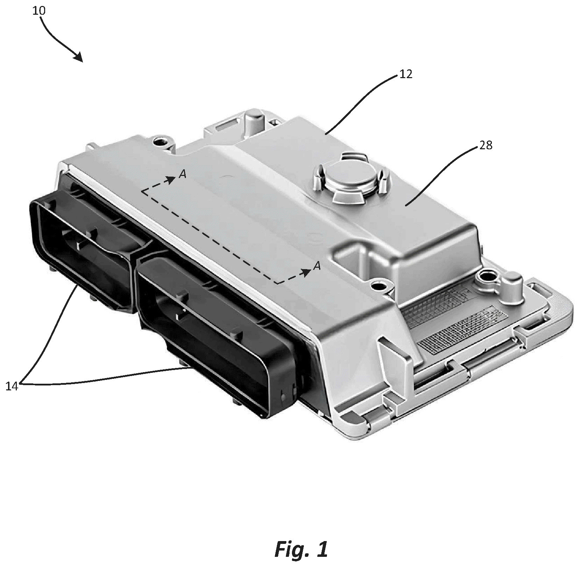

Referring to **FIG. 1****,** a perspective view illustrating an automobile electronic control unit 10 (hereinafter "the ECU 10") is shown. The ECU 10 may include a housing 12 and one or more connection receptacles 14 extending from the housing 12. The connection receptacles 14 may be adapted to receive connectors of wiring harnesses (not shown) for establishing electrical connections between electronic components within the housing 12 and various external systems and components in a vehicle (e.g., motor control systems, transmission control systems, braking systems, driver assistance systems, etc.).

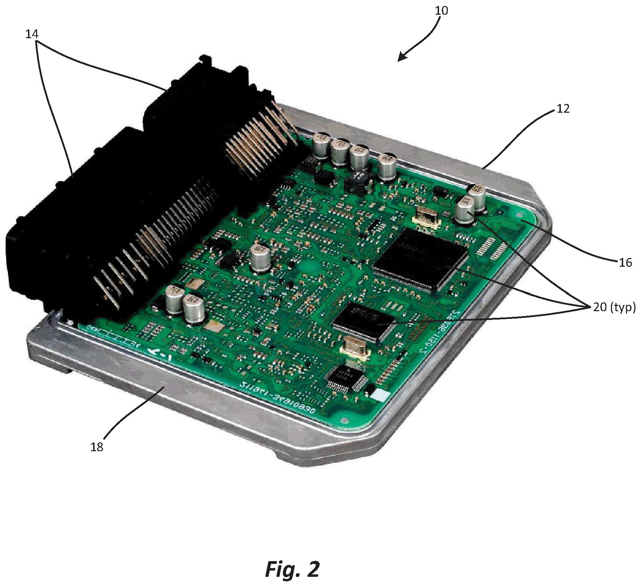

Referring to **FIG. 2****,** a cutaway view illustrating the ECU 10 with an upper portion of the housing 12 removed is shown. The ECU 10 may include a printed circuit board 16 (hereinafter "the PCB 16") mounted within the housing 12. For example, the PCB 16 may be fastened to a lower portion 18 of the housing 12 in intimate mechanical and thermal contact therewith (e.g., using metal fasteners, thermally conductive adhesives, etc.). As will be familiar to those of skill in the art, the PCB 16 may include a variety of the complex electronic circuits and components 20 (hereinafter "the electronic components 20") mounted thereon, including semiconductor devices, passive components, radio frequency communications devices, connection devices, etc. which may be electrically connected to the connection receptacles 14.

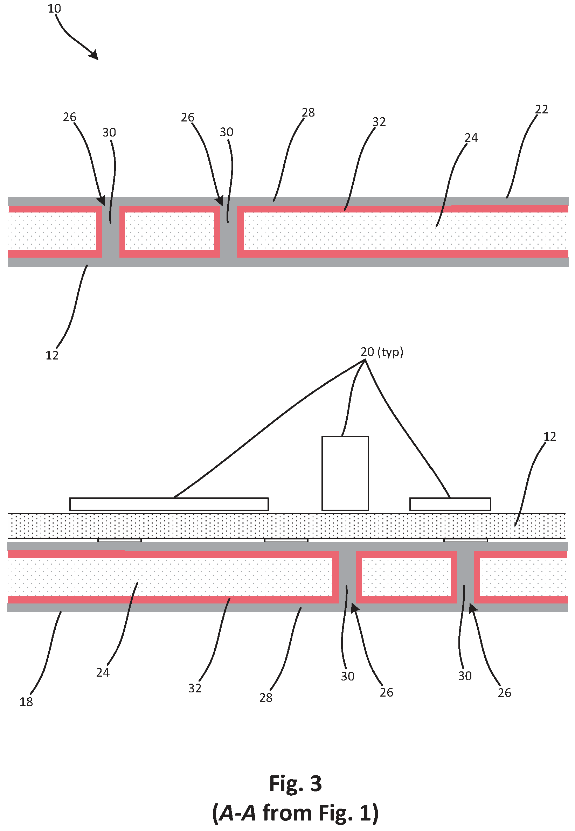

The housing 12 may be formed of metalized plastic. That is, the housing 12 may include a plastic base structure having a thin, metallic coating covering interior and exterior surfaces thereof. This is best shown in **FIG. 3****,** which provides a cross-sectional view illustrating a portion of the ECU 10, including a lower portion 18 of the housing 12, the PCB 16, the electronic components 20, and an upper portion 22 of the housing 12. The base structure 24 of the housing 12 may be formed a thermoplastic material (e.g., polycarbonate, acrylonitrile butadiene styrene, polyvinyl chloride, polypropylene, polystyrene, etc.). The base structure 24 may be formed of a single, unitary, contiguous piece of plastic. Alternatively, the base structure 24 may be formed of multiple pieces of plastic that are fastened together. In either case, the base structure 24 may be formed using any suitable manufacturing process, including, but not limited to, molding, 3D printing, etc.

The base structure 24 may include holes 26 formed therein extending between interior and exterior surfaces thereof. The holes 26 may be round, and may each have a depth in a range of 1 millimeter to 2 millimeters (i.e., equal to the thickness of the wall of the base structure 24) and a diameter in a range of 0.5 millimeters to 2 millimeters. The present disclosure is not limited in this regard. **FIG. 3** depicts two holes 26 being formed in each of the lower portion 18 and upper portion 22 of the housing 12. This is not intended to be limiting, and the positions, arrangement, and total number of the holes 26 may be varied without departing from the scope of the present disclosure. Furthermore, while the holes 26 are shown as being cylindrical and of uniform diameter, examples of the present disclosure are contemplated wherein the upper and/or lower termini of the holes 26 are countersunk.

Interior and exterior surfaces of the base structure 24 may be covered by a thin, metallic coating 28. The metallic coating 28 may also fill the holes 26 to form conductive vias 30 that extend between the interior and exterior of the housing 12. The metallic coating 28 may be formed of a metal having good thermal conductivity. Examples of such metals include, but are not limited to, copper, aluminum, silver, gold, zinc, nickel, etc. A layer of priming agent 32 may be disposed directly on the base structure 24 and may be interposed between the surface of the base structure 24 and the metallic coating 28 to facilitate good adhesion of the metallic coating 28. Examples of suitable priming agents include, but are not limited to, thermally conductive primers or coatings such as Graphitlack GRAPHIT 33, manufactured by KONTAKT CHEMIE, and 10P2-3, manufactured by AKZONOBEL. The priming agent 32 may be applied to the base structure 24 using a spaying or dipping process, and the metallic coating 28 may be applied using a spraying process, a plating process, or a deposition process as further described below. The metallic coating 28 may have a thickness in a range of 1 micron to 3 millimeters. The present disclosure is not limited in this regard.

The metalized plastic housing 12 may provide distinct advantages relative to traditional housings that are formed entirely of metal. For example, since the base structure 24 of the housing 12 is formed of plastic, the housing 12 may be significantly lighter and significantly less expensive to produce than traditional, metal housings. Owing to the metallic coating 28, the housing 12 may exhibit excellent thermal conductivity between the interior and the exterior of the housing 12. For example, heat generated by the electronic components 20 within the housing 12 may be conducted from the metallic coating 28 on the interior surfaces of the housing 12, through the vias 30, to the metallic coating 28 on the exterior surfaces of the housing 12, where it may be dissipated to the surrounding atmosphere.

While the metalized plastic housing 12 has been described above as being used as a housing for an ECU, it will be appreciated that the housing 12 may be similarly employed as a housing for other electronic devices. For example, the housing 12 may be employed in a transmission control (TCM) module, anti-lock braking system (ABS) module, electronic stability control (ESC) module, telematics control unit (TCU), airbag control module (ACM), etc. The present disclosure is not limited in this regard.

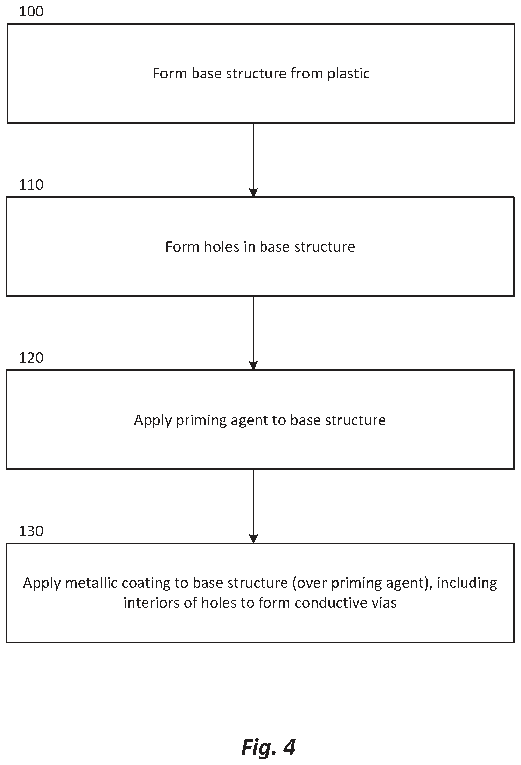

Referring to **FIG. 4****,** a flow diagram illustrating a method for manufacturing the metalized plastic housing 12 described above is shown. The method will be described with reference to the housing 12 as shown in **FIGS. 1-3****.**

In block 100 of the method shown in **FIG. 4****,** the plastic base structure 24 may be formed from plastic. The base structure 24 may be formed of a thermoplastic material (e.g., polycarbonate, acrylonitrile butadiene styrene, polyvinyl chloride, polypropylene, polystyrene, etc.) using any suitable manufacturing process, including, but not limited to, molding, 3D printing, etc. The base structure 24 may be formed of a single, unitary, contiguous piece of plastic. Alternatively, the base structure 24 may be formed of multiple pieces of plastic that are fastened together. In either case, the base structure 24 may be formed using any suitable manufacturing process, including, but not limited to, molding (e.g., injection molding, compression molding, etc.), 3D printing, etc. The base structure 24 may be formed of a single, unitary, contiguous piece of plastic, or may be formed of multiple pieces of plastic that are subsequently fastened together using adhesives and/or mechanical fasteners. The present disclosure is not limited in this regard.

In block 110 of the method shown in **FIG. 4****,** the holes 26 may be formed in the base structure 24. The holes 26 may be formed as part the formation of the base structure 24 in block 100 of the method (e.g., during the molding process or the 3D printing process used to form the base structure 24). Alternatively, the holes 26 may be formed in the base structure 24 after the base structure 24 is already formed, such as by drilling, cutting, punching, etc. The holes 26 may be round, and may each have a depth in a range of 1 millimeter to 2 millimeters (i.e., equal to the thickness of the wall of the base structure 24) and a diameter in a range of 0.5 millimeters to 2 millimeters. The present disclosure is not limited in this regard.

In block 120 of the method shown in **FIG. 4****,** the priming agent 32 may be applied to the base structure 24. The priming agent 32 may include one or more thermally conductive primers or coatings such as Graphitlack GRAPHIT 33, manufactured by KONTAKT CHEMIE, and 10P2-3, manufactured by AKZONOBEL, and may be applied to the base structure 24 using a spaying or dipping process, for example. The priming agent 32 may cover the entire base structure 24, including interior and exterior surfaces of the base structure 24 and interior surfaces of the holes 26. Alternatively, the priming agent 32 may cover only select portion of the base structure 24 (e.g., portions intended to be covered by the metallic coating 28). The priming agent 32 may be entirely omitted. The present disclosure is not limited in this regard.

In block 130 of the method shown in **FIG. 4****,** the metallic coating 28 may be applied to the base structure 24. For example, the metallic coating 28 may be applied to portions of the base structure 24 that were coated with the priming agent 32 in block 120 of the method, wherein the priming agent 32 promotes adhesion of the metallic coating 28. The metallic coating 28 may also fill the holes 26 to form the conductive vias 30 that extend between the interior and exterior of the housing 12. The metallic coating 28 may be formed of a metal having good thermal conductivity (e.g., copper, aluminum, silver, gold, zinc, nickel, etc.) and may be applied using any suitable process. Such processes include, but are not limited to, flame spraying, electroless plating, electroplating, and vapor deposition. The metallic coating 28 may have a thickness in a range of 1 micron to 3 millimeters. The present disclosure is not limited in this regard.

As used herein, an element or step recited in the singular and proceeded with the word "a" or "an" should be understood as not excluding plural elements or steps, unless such exclusion is explicitly recited.

While the present disclosure makes reference to certain examples, numerous modifications, alterations and changes to the described examples are possible without departing from the scope of the present disclosure, as defined in the appended claim(s). Accordingly, it is intended that the present disclosure not be limited to the described examples, but that it has the full scope defined by the language of the following claims, and equivalents thereof.

## Claims

1. An automobile electronic control unit (ECU) comprising:
a housing comprising:
a base structure formed of plastic and having a plurality of holes formed therein, wherein each of the plurality of holes extends from an interior surface of the base structure to an exterior surface of the base structure; and
a metallic coating covering the interior and exterior surfaces of the base structure and filling the plurality of holes to form conductive vias;
a printed circuit board disposed within the housing;
a plurality of electronic components mounted on the printed circuit board; and
a connection receptacle extending from the housing and adapted to receive a connector of a wiring harness, the connection receptacle electrically connected to the plurality of electronic components.

2. The automobile ECU of claim 1, wherein the base structure is formed of a thermoplastic material, preferably wherein the base structure is formed of one of polycarbonate, acrylonitrile butadiene styrene, polyvinyl chloride, polypropylene, and polystyrene.

3. The automobile ECU of claims 1 or 2, wherein each of the holes has a depth in a range of 1 millimeter to 2 millimeters

4. The automobile ECU of any of the preceding claims wherein each of the holes has a diameter in a range of 0.5 millimeters to 2 millimeters.

5. The automobile ECU of any of the preceding claims comprising:
a layer of priming agent interposed between the metallic coating and the interior and exterior surfaces of the base structure;
wherein the metallic coating has a thickness in a range of 1 micron to 3 millimeters;
wherein the metallic coating is formed of one of copper, aluminum, silver, gold, zinc, and nickel.

6. A housing for an electronic device, the housing comprising: a base structure formed of plastic and having a plurality of holes formed therein, wherein each of the plurality of holes extends from an interior surface of the base structure to an exterior surface of the base structure; and a metallic coating covering the interior and exterior surfaces of the base structure and filling the plurality of holes to form conductive vias.

7. The housing of claim 6, wherein the base structure is formed of a thermoplastic material, preferably wherein the base structure is formed of one of polycarbonate, acrylonitrile butadiene styrene, polyvinyl chloride, polypropylene, and polystyrene.

8. The housing of claim 6 or 7, wherein each of the holes has a depth in a range of 1 millimeter to 2 millimeters and/or wherein each of the holes has a diameter in a range of 0.5 millimeters to 2 millimeters.

9. The housing of any of the claims 6-8 comprising a layer of priming agent interposed between the metallic coating and the interior and exterior surfaces of the base structure;
wherein the metallic coating has a thickness in a range of 1 micron to 3 millimeters;
wherein the metallic coating is formed of one of copper, aluminum, silver, gold, zinc, and nickel.

10. The housing of any of the preceding claims 6-9, being a housing as referred to in any of the claims 1-5.

11. A method of manufacturing a metalized housing for an electronic device, the method comprising:
forming a base structure from plastic, the base structure having a plurality of holes extending between interior and exterior surfaces thereof;
applying a priming agent to the interior and exterior surfaces of the base structure; and
applying a metallic coating over the priming agent, wherein the metallic coating fills the plurality of holes to form conductive vias.

12. The method of claim 11, wherein the base structure is formed using one of a molding process and a 3D printing process, and/or
wherein the priming agent is applied using one of a spraying process and a dipping process.

13. The method of claim 11 or 12, wherein the metallic coating is applied using of a flame spraying process, an electroless plating process, an electroplating process, and a vapor deposition process.

14. The method of any of the claims 11-13, wherein the base structure is formed of a thermoplastic material, preferably wherein the base structure is formed of one of polycarbonate, acrylonitrile butadiene styrene, polyvinyl chloride, polypropylene, and polystyrene.

15. The method of any of the preceding claims 11-14, wherein the metallic coating has a thickness in a range of 1 micron to 3 millimeters.
